# EUROPEAN PATENT SPECIFICATION

(11) **EP 3 822 997 B1**
(45) Date of publication and mention of the grant of the patent: **09.07.2025**
(21) Application number: 19814797.7
(22) Date of filing: 18.05.2019
(51) Int. Cl.: H01G 4/228, H01G 2/02, H01G 2/06, H01G 2/08, H01G 4/30, H01G 4/38, H01G 9/008, H01L 23/28, H01L 23/36, H01L 23/492, H05K 1/02

(54) **BUSBAR LAMINATE, ELECTRONIC COMPONENT MOUNTING MODULE INCLUDING SAME, AND METHOD OF MANUFACTURING BUSBAR LAMINATE**
SAMMELSCHIENENLAMINAT, MODUL ZUR MONTAGE ELEKTRONISCHER KOMPONENTEN DAMIT UND VERFAHREN ZUR HERSTELLUNG EINES SAMMELSCHIENENLAMINATS
STRATIFIÉ DE BARRE OMNIBUS, MODULE DE MONTAGE DE COMPOSANT ÉLECTRONIQUE POURVU DE CELUI-CI, ET PROCÉDÉ DE FABRICATION DE STRATIFIÉ DE BARRE OMNIBUS

(30) Priority: 05.06.2018 JP 2018107427
(43) Date of publication of application: 19.05.2021
(73) Proprietor: Nippon Chemi-Con Corporation, Tokyo 141-8605 (JP)
(72) Inventor: ICHIKURA, Osamu, Tokyo 141-8605 (JP); YAMAYA, Koji, Tokyo 141-8605 (JP); ABE, Tsubasa, Tokyo 141-8605 (JP); KUROSU, Mitsuru, Tokyo 141-8605 (JP); TAMAI, Yuya, Tokyo 141-8605 (JP)
(74) Representative: Baldus, Oliver
(86) International application number: PCT/JP2019/019816
(87) International publication number: WO 2019/235189

(56) References cited:
- EP-A1- 2 717 658
- WO-A1-2017/177847
- JP-A- 2006 005 096
- JP-A- 2006 005 096
- JP-A- 2009 117 805
- JP-A- 2009 259 915
- JP-A- 2010 110 170
- JP-A- 2014 192 175
- JP-A- H10 340 630
- JP-U- H0 626 117
- US-A1- 2018 027 646

## Description

### [Technical Field]

The present invention is to enable the use of reflow soldering by aligning the height of the solder mounting surface with the bus bar and the cathode of the stacked anode, the electronic component module of the surface mount type using a bus bar and the like. [Background]

The conductive material large current is applied in the module for mounting a plurality of electronic components resistance is lowered by using a metal plate (bus bar), it is known that it is possible to improve the heat dissipation while reducing the heat generation. When using a large current, so-called printed wiring board or the like which is commonly used for mounting a small electronic device since the heat dissipation is not caught is accumulated, there is a concern that the electronic component or the like is thermally damaged.

Therefore, for example, in the case of mounting a plurality of capacitors, the bus bar and the cathode of the anode is laminated (bonded) via an insulating layer (e.g., a coating layer of an insulating sheet or an insulating material), by mounting a plurality side by side on one surface of the bonded bus bar, to improve the heat dissipation.

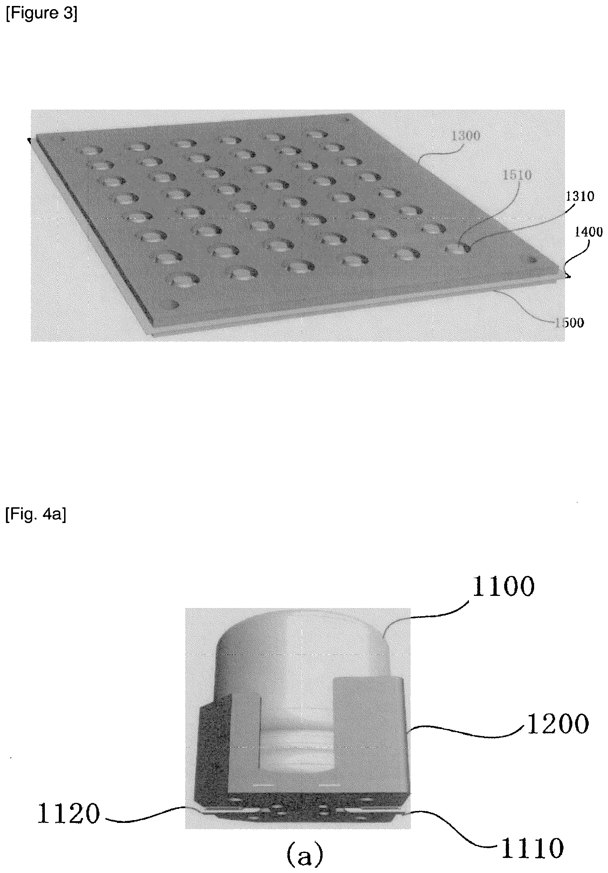

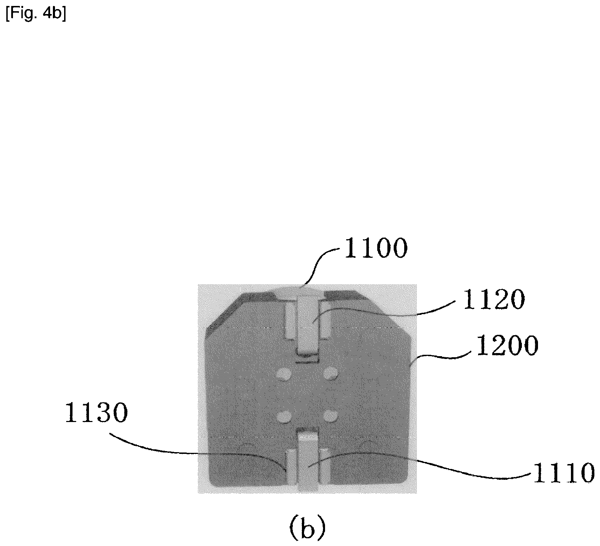

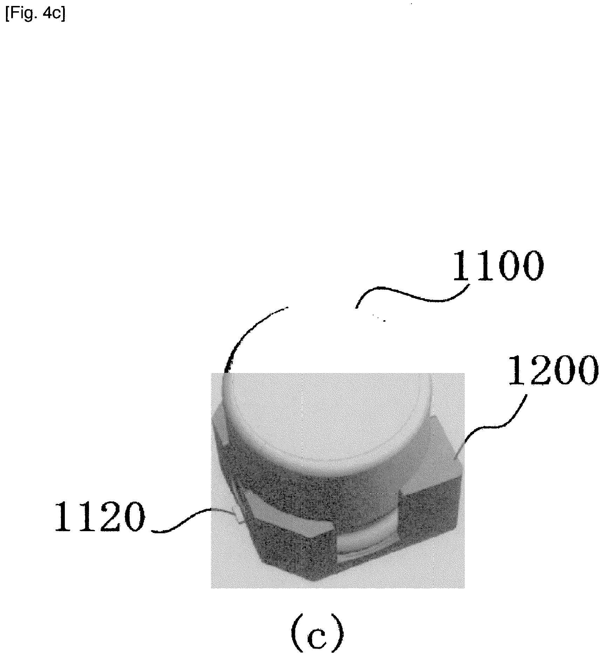

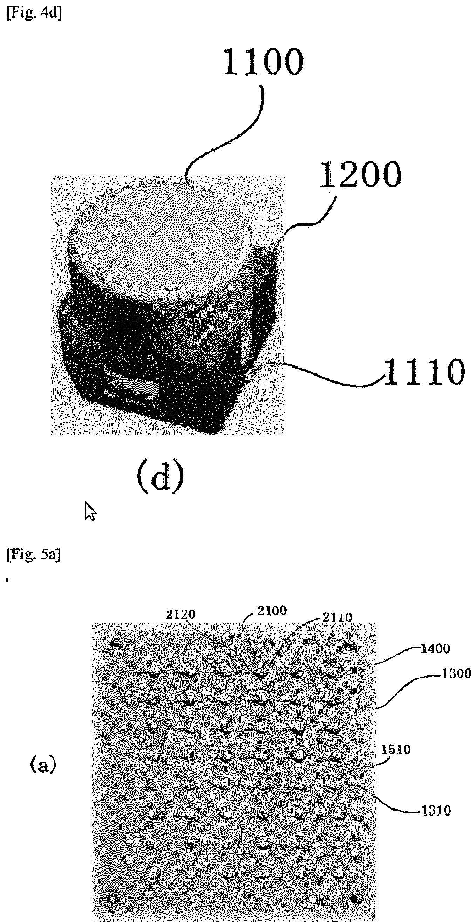

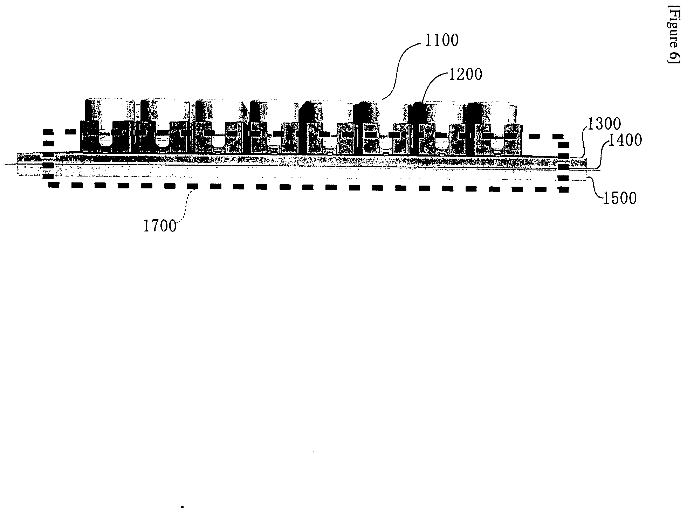

In FIG. 4 and the description portion of Patent Document 1 below, "the capacitor module 31 of the second embodiment shown in FIG. 4, the substrate 32, the first on both surfaces of the insulating sheet 33 has a structure obtained by bonding a second metal plate 34 and 35. FIG. 6, the insulating sheet 33 is shown in a plan view. The insulating sheet 33, in this embodiment, made of silicone resin, has a thickness of about 0.1 to 0.05mm. However, the insulating sheet 33 may be constructed using another synthetic resin such as epoxy resin (resist)." It is described.

Patent Document 1 is disclosed that bonded while sandwiching the insulating sheet 33 between the first metal plate 34 and the second metal plate 35, the lead terminal 3a,3b of the multilayer capacitor 3 is vertically penetrated upright to the metal plate, the lead terminal 3a,3b is soldered to a metal plate 34, 35.

As shown in FIG. 4 of Patent Document 1, the lead terminal 3a is soldered by solder 16 to the bottom surface of the upper metal plate 34, the lead terminal 3b is soldered by solder 17 to the bottom surface of the lower metal plate 35. Therefore, in such a structure, just by a height corresponding to the thickness of the insulating sheet 33 and the lower metal plate 35, the height of the soldered pair of lead terminal 3a,3b are different from each other. Soldering work in this case, although no problem occurs when it is individually soldered by manual operation, can not cope with this when considering the mass production process expecting a certain degree of throughput using flow solder or the like.

Document JP2006005096A relates to a control circuit on one surface of a circuit board and an electronic component. Document JP2010110170A discloses a circuit structure body and an electric joint box. Other relevant prior art can be found in documents JP2014192175A; JP2009117805A; US2018/027646A1; EP2717658A1 or WO2017/177847A1.

### [Prior art documents]

### [Patent Document]

[Patent document 1] JP-A-2001-178151

### [Summary of the invention]

### [Problem solved by the invention]

Conventionally, when mounting the electronic components of a plurality of surface mount type or lead insertion type to two bus bars stacked, the mounting surface height of the bus bar and the cathode of the anode (i.e., the height of the soldering point to each bus bar of each lead terminal of the anode and the cathode) is different, it is impossible to use a reflow solder or the like, mounting work of the electronic components there is a problem that becomes complicated.

That is, when the soldering height of the pair of lead terminals as in the prior art is different from each other, but there is no problem if the soldering work by hand, if you attempt to utilize a reflow soldering process that is frequently used in such a mass production process, the soldering point height is different the process execution becomes difficult. Each bus bar has a certain thickness in consideration of heat dissipation or the like as much as the large current, the difference in the height of the soldering point corresponding to the thickness of the bus bar electrode body for reflow soldering process is not negligible.

Therefore, each lead terminal of the electronic component module used by bonding the cathode bus bar and the anode bus bar (surface mount type), a structure that can be soldered to each bus bar by utilizing a higher reflow solder mass production efficiency is required. The present invention has been made in view of the above problems, it was possible to use the reflow solder by aligning the height of the solder mounting surface in the bus bar and the cathode of the anode stacked, the electronic component module of the surface mount type using a bus bar and the like and an object thereof is to provide.

### [A means for solving the problem]

Bus bar stacked body according to claim 1 comprising a first bus bar and the second bus bar and each comprising a region for soldering the external terminals of the electronic component is laminated by insulation, the first bus bar is provided with an opening, the second bus bar protrudes to the first bus bar side, a protrusion body is a region to be soldered is provided with a protrusion body, the protrusion body of the second bus bar is disposed at a position corresponding to the opening, and a region for soldering the protrusion body and the region for soldering the first bus bar, the external terminals of the electronic component by reflow soldering is characterized in that the same height to the extent possible.

Further, the electronic component mounting module according to claim 3 of the present invention, preferably the tip of the first lead terminal is characterized in that it is disposed in the top of the head of the soldered protrusion body.

Further, the electronic component mounting module of the present invention is characterized in that the bus bar stacked body further preferably including a soldered region is resin molded.

Further, the electronic component mounting module of the present invention, more preferably of the bus bar stacked body, the back surface with respect to the mounting side of the electronic component,characterized in that it comprises a heat sink bonded flush.

Further, in the method of manufacturing a bus bar stacked body according to claim 6 of the present invention, in the method of manufacturing a bus bar stacked body in which a first bus bar and a second bus bar, each of which is provided with a region for soldering the first bus bar and the external terminal of the second electronic component, are laminated while being insulated from each other, the step of forming an opening in the first bus bar and the step of forming a protrusion body, which is a region for projecting and soldering to the first bus bar side, on the second bus bar, are performed, and then the step of arranging the protrusion body of the second bus bar at a position corresponding to the opening and insulating and laminating the first bus bar and the second bus bar,the region for soldering of the first bus bar and the region for soldering of the protrusion body are the same height to the extent that the external terminal of the electronic component can be soldered by reflow soldering.

### [Effect of the invention]

The stacked anode of the bus bar and the cathode of the bus bar and the height of the solder mounting surface is aligned to enable use of reflow solder, it is possible to provide a surface mount type electronic component module or the like using a bus bar.

### [BRIEF DESCRIPTION OF THE DRAWINGS]

[Figure 1] It is a perspective view for explaining the overall outline of the electronic component mounting module.
[Fig. 2a] It is a cross-sectional view illustrating a configuration embodiment in the case of cutting at the center of the capacitor.
[Fig. 2b] It is a cross-sectional view illustrating a configuration embodiment in the case of cutting at the center of the capacitor.
[Figure 3] It is a diagram for explaining the overall configuration outline of the bus bar stacked body of the present embodiment.
[Fig. 4a] It is a diagram for explaining a capacitor configured as a surface mount type.
[Fig. 4b] It is a diagram for explaining a capacitor configured as a surface mount type.
[Fig. 4c] It is a diagram for explaining a capacitor configured as a surface mount type.
[Fig. 4d] It is a diagram for explaining a capacitor configured as a surface mount type.
[Fig. 5a] Second embodiment in which a surface-mounted chip-type ceramic capacitor is mounted
   It is a schematic diagram for explaining an electronic component mounting module of.
[Fig. 5b] Second embodiment in which a surface-mounted chip-type ceramic capacitor is mounted
   It is a schematic diagram for explaining an electronic component mounting module of.
[Fig. 5c] Second embodiment in which a surface-mounted chip-type ceramic capacitor is mounted
   It is a schematic diagram for explaining an electronic component mounting module of.
[Figure 6] A typical example of a capacitor mounting module molded with resin shown by a broken
   line is described.
   It is a diagram.

### [Form for implementing the present invention]

Bus bar stacked body exemplified in this embodiment, a plurality of electronic components such as a capacitor for example utilizing a large current, are surface-mounted side by side in a planar shape by reflow solder, it can be utilized in an in-vehicle application or the like. Conventionally, the bus bar stacked body, since each of the upper layer side of the bus bar and the lower layer side of the bus bar has a considerable thickness, the soldering point of each bus bar lead terminals of the electronic component to be mounted is soldered, the thickness in the height direction corresponding to the difference has occurred.

Further, the technical trend of the electronic component mounting module, with the progress of miniaturization and weight reduction, the chipping of the electronic components to be mounted is further advanced. If, when the chip component and the lead terminal parts are mixed in the electronic component to be mounted, since the process since the soldering for connecting and fixing electrically and mechanically becomes two steps increases the cost, it is preferable to be unified to any, at present it is expected to chip the capacitor and the coil.

According to the configuration proposed in the embodiment, the process of soldering quality confirmation is an essential step after reflow soldering is facilitated, by confirming the solder fillet image processing or visually, it is possible to evaluate and confirm the quality of the soldering. Further,
it is preferable to have a step height of 0.6 mm or less to allow for reflow soldering, and even more preferable to have a step height of 0.3 mm or less. In this embodiment, the difference in the height of soldering to each bus bar can be made the same height within such a reflow soldering possible.

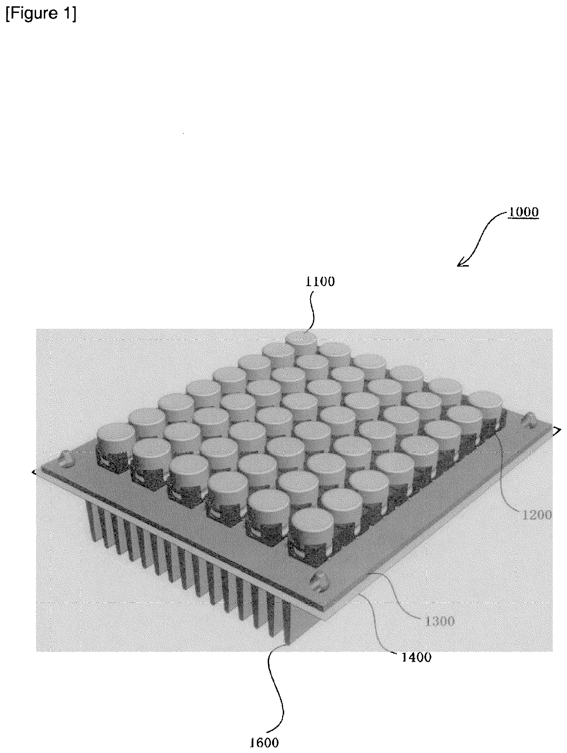

Figure 1 is a perspective view for explaining the overall outline of the electronic component mounting module 1000. As shown in FIG. 1, the electronic component mounting module 1000 includes a first bus bar 1300 and the insulating sheet 1400 and the second bus bar 1500 (not shown in FIG. 1), on the first bus bar 1300 the capacitor 1100 in a state of being mounted on the pedestal 1200 is a plurality surface mounted. Further, on the outer surface side of the second bus bar 1500, the heat sink 1600 is surface mounted (surface contact).

As shown in FIG. 1, the bus bar stacked body is capable of supplying a large current, and because it is also excellent in heat dissipation, even mounted electronic components such as a large number of capacitors 1100 in a high density, the electronic component is thermally damaged it is possible to avoid. Especially capacitor 1100 is known to be weak to high heat, it is possible to maintain the characteristics of high reliability and high durability in the bus bar stacked body of the present invention. Each bus bar 1300 and 1500 is composed of a metal having a certain degree of thickness in consideration of a large current and heat dissipation, which has become a considerably strong characteristic strength can be obtained. Therefore, even a capacitor or the like whose life is greatly affected by heat can be integrated without problems.

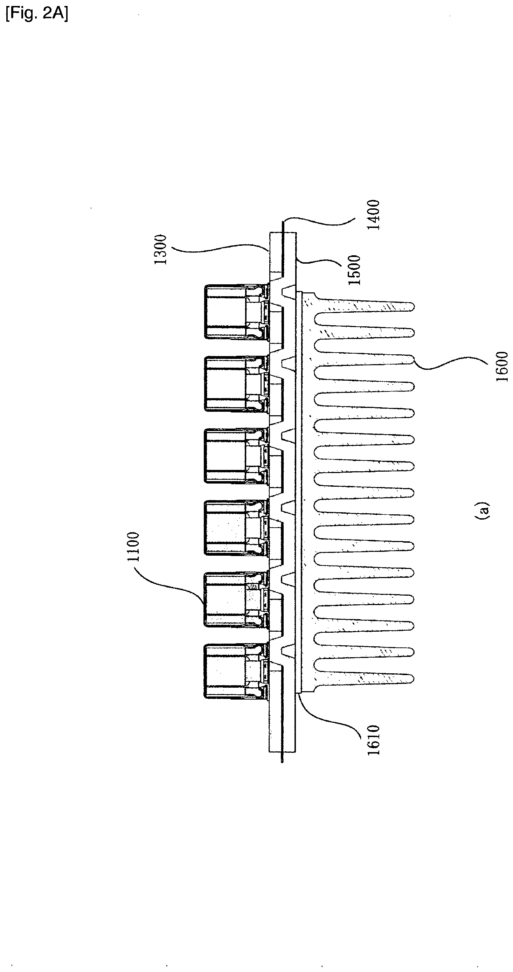

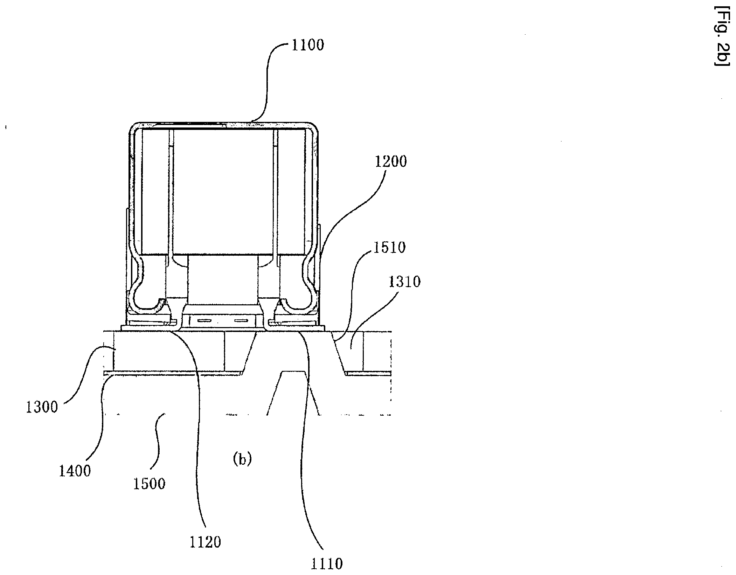

Further, FIG 2a is a cross-sectional view illustrating a configuration embodiment when cut at the center of the capacitor 1100, FIG 2b is an enlarged view thereof. In FIG. 2a, the outer surface side of the second bus bar 1500 is affixed with a heat conductive film 1610 and the heat sink 1600 on one surface, thereby efficiently dissipating heat of the second bus bar 1500 to the outside. On the outersurface side of the second bus bar 1500, since the protrusion obstacles such as protrusion and solder fillet of the terminal is not present, it is possible to affix the heat conductive film 1610 and the heat sink 1600 in a large area contact flush, the heat dissipation characteristics are improved. Incidentally, the heat conductive film 1610 may be provided only a direct heat sink 1600 is omitted.

Further, as shown in FIG. 2b, the first electrode with solder protrusion body 1510 provided by the second bus bar 1500 is disposed in the convex opening 1310 of the first bus bar 1300, the outer surface of the first bus bar 1300 is substantially the same height to the extent that can reflow solder.

Then, the first lead terminal 1110 and the second lead terminal 1120 is inserted into the pedestal 1200 is bent at its bottom surface, and can be handled as a surface mount type electronic component by the pedestal 1200 is set to the capacitor 1100. Further, as can be understood from 2b, the first lead terminal 1110 is reflow soldered to the flat top of the first electrode soldered protrusion body 1510. Here, at least the distal end portion of the first lead terminal 1110, in a state of slightly protruding from the pedestal 1200, it is assumed that fitted without protruding from the flat top of the first electrode soldered protrusion body 1510.

Thus, when observed from above, since the distal end portion of the first lead terminal 1110 becomes visible or the like (visual recognition or camera image acquisition and its processing) possible (visual camera or camera image acquisition and its processing), the state of the solder fillet formed around it it is possible to perform the quality check of the reflow solder by observation. Further, the distal end portion of the second lead terminal 1120, in a state of slightly protruding from the pedestal 1200, is reflow soldered to the first bus bar 1300.

With such a configuration, the top of the first electrode soldered protrusion body 1510, and the plane of the peripheral portion of the convex opening 1310 of the first bus bar 1300, it is possible to align the height of each other, the use of reflow solder is also facilitated.

Figure 3 is a diagram for explaining the overall configuration outline of the bus bar stacked body of the present embodiment. In FIG. 3, the bus bar stack comprises a first bus bar 1300 described on the paper top layer side, a second bus bar 1500 described on the lower layer side, and an insulating sheet 1400 disposed between the first bus bar 1300 and the second bus bar 1500. The second bus bar 1500, the flat top of the first electrode soldered protrusion body 1510 protruding to the first bus bar 1300 side, the first lead terminal of the electronic component to be surface-mounted is reflow soldered
to the top side of the paper surface. Further, the first electrode soldered protrusion body 1510 is disposed so as to be non-contact by providing a desired clearance in the convex opening 1310 provided in the first bus bar 1300 at a position corresponding to the first electrode soldered protrusion body 1510.

The first bus bar 1300, the second lead terminal 1120 of the electronic component to be surface-mounted at the peripheral portion of the convex opening 1310 is reflow soldered to the top surface side of the paper surface. That is, the electronic component of the surface mount type shown in this embodiment is assumed to be reflow soldered on the mounting side. More particularly in the bus bar stacked body of FIG. 3, the electronic component on the upper surface of the first bus bar 1300 on the top surface side of the paper surface is intended to be surface-mounted, the lead terminal of the electronic component by reflow soldering on the upper surface of the first bus bar 1300 on the top
surface side of the paper surface It will be fixed with solder. Each lead terminal is not intended to be inserted and fixed to the bus bar as already described, it is intended to be soldered by mounting in surface contact is bent at the base bottom surface.

Each bus bar 1300 and 1500 are formed of a metal having a considerable thickness, which can flow a large current with excellent thermal conductivity with low resistance. The smooth heat dissipation effect of the bus bar stacked body, it is possible to prevent thermal damage of a plurality of electronic components mounted on the bus bar stacked body.

As can be understood from FIG. 3, the portion corresponding to the first electrode solder- attached protrusion body 1510 second bus bar 1500 is provided, the convex opening 1310 having a larger diameter is provided in the first bus bar 1300. The second lead terminal 1120 of the surface mount electronic component mounted on the outer surface side of the first bus bar 1300 is electrically and mechanically reflow soldered fixed to the first bus bar 1300 at the periphery of the convex opening 1310. Incidentally, the insulating sheet 1200 may be formed by application of an insulating material such as various films having insulating properties (e.g., polyimide film) or a resist.

Incidentally, in FIG. 3 or the like, between the first bus bar 1300 and the second bus bar 1500, in order to more reliably maintain the insulating characteristics in the convex opening 1310 at the time of reflow soldering or the like, the first electrode soldered protrusion body 1510 of the insulating sheet 1400 the opening area corresponding to can be smaller than the opening area of the convex opening 1310.

Further, from the opening of the location of the insulating sheet 1400 as only the first electrode solder-attached protrusion body 1510 is exposed, the planar portion of the other second bus bar 1500 can be made so as not to be exposed. Thus, even if the reflow solder leaks to the second bus bar 1500 side along its inner peripheral wall adheres to the excessively convex opening 1310 edge, the solder to the second bus bar 1500 is blocked by the insulating sheet 1400 becomes what can not be in contact, it becomes possible to ensure reliable and safe insulation properties. More preferably, by placing and applying an insulating material such as a resist agent on the side wall of the first
electrode soldered protrusion body 1510 (tapered in the drawing 2a,2b) and the protrusion body opening 1310 (in the drawing 2a,2b the perpendicular peripheral wall), the insulating properties are further improved.

Fig. 4a, 4b, 4c, 4d is also a diagram illustrating a capacitor 1100 exemplified in this embodiment configured as a surface-mount type. Although the illustrated 4a, 4b, 4c, 4d illustrates a capacitor configuration as a typical example of an electronic component, the electronic component of the present invention is not limited to a capacitor, but may be any surface mount type electronic device. As shown in FIG. 4a, 4b, 4c, 4d, the capacitor 1100 by being fitted while inserting the lead terminals 1110 and 1120 to the pedestal 1200, can be mounted by surface contacts at the bottom surface of the pedestal 1200.

Further, the first lead terminal 1110 and the second lead terminal 1120, respectively are bent along the bottom surface is inserted through the pedestal 1200, at least the distal end portion of the pedestal 1200 a state protruding from the edge portion. Therefore, when viewed from above the capacitor 1100 and the pedestal 1200, each tip portion of the first lead terminal 1110 and the second lead terminal 1120 from the edge of the pedestal 1200 is a state that can be visually recognized.

Further, on the bottom surface of the pedestal 1200, a pair of auxiliary terminals 1130 around each of the first lead terminal 1110 and the second lead terminal 1120 are provided, respectively, in the reflow soldering process, with the first lead terminal 1110 and the second lead terminal 1120 by each auxiliary terminal 1130 is also soldered, so that the fixing strength is increased to improve the impact resistance and vibration resistance.

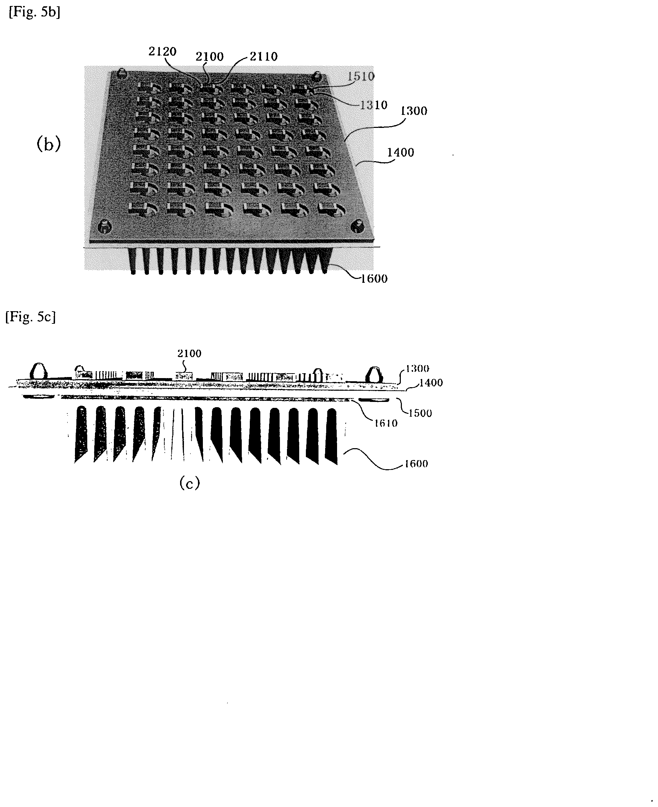

FIG. 5a, 5b, 5c is a schematic diagram for explaining the electronic component mounting modules of the second embodiment in which the surface-mounted chip-type ceramic capacitors 2100 are mounted. Chip-type ceramic capacitor 2100 includes a first electrode 2110 and the second electrode 2120, with the first electrode 2110 is reflow soldered to the flat top of the first electrode solder with protrusion body 1510, the second electrode 2120 is reflow soldered to the first bus bar 1300. As already described, the first electrode soldered protrusion body 1510, a portion of the second bus bar 1500 of the flat plate shape is obtained by being convex, a part of the second bus bar 1500.

By forming in this way, a portion of the solder fillet with respect to the first electrode 2110, more preferably all, so that it is formed in the flat top of the first electrode solder-attached protrusion body 1510, the observation and evaluation of the plan view from above, the reflow soldering process quality check and confirmation can be easily and quickly carried out. Further, by the entire bottom surface of the first electrode 2110 and the second electrode 2120 is soldered, since the heat dissipation characteristics as well as the vibration resistance and impact resistance is improved mounting strength is increased is improved, the reliability and durability and life of the ceramic capacitor 2100 will be improved. Here, as the external terminal of the surface-mounted component to be reflow soldered may be an electrode terminal exemplified by, for example, a lead terminal and a diagram 5a, 5b, 5c exemplified in FIG 2a,2b.

Figure 6 is a diagram illustrating a typical example of a capacitor mounting module molded with a resin 1700 shown by a broken line. 6 shows a state in which a portion of the first bus bar 1300 and the second bus bar 1500 and the capacitor 1100 (typically the lower half including a pedestal) is molded with resin 1700. Although not shown explicitly in FIG.6, the lead terminals 1110 and 1120 are those already soldered.

As shown in FIG. 6, if molded with a resin 1700, the resin 1700, and the surrounding space of the first electrode solder-attached protrusion body 1510, since it is filled also enters into the convex opening 1310, not only the heat dissipation characteristics are improved, the overall strength is made to increase greatly, vibration resistance and impact resistance and durability is improved. Further, since the capacitor 1100 in addition to the soldering is molded integrated with each bus bar 1300 and 1500, the capacitor 1100 becomes to be fixed even in the resin 1700, so that the impact resistance is also greatly improved.

In particular, as is apparent from FIGS. 3 and 6, since the surface area is an increased bus bar 1300 and 1500 is provided with an uneven shape rather than a flat bus bar of the plate-shaped flat surface, it becomes possible to secure a large contact area between the resin 1700, the heat dissipation characteristics and adhesive strength can be increased by this. Even when a large vibration or impact or acceleration is applied, since the shape retaining the entire resin 1700, as compared with the case of fixing with only the lead terminals 1120 and 1110, the load on the lead terminals 1120 and 1110 can be reduced. Further, although not shown, the resin 1700 may be provided with an optional path hole for degassing the capacitor 1100. Further, in a state where the heat sink 1600 is provided, it may be further molded with a resin 1700.

Electronic component illustrated in this embodiment, it is not necessary to penetrate the lead terminal protruding from the electronic component to the insertion hole of the bus bar. Therefore, in the case of surface mounting the electronic component, it is possible to freely design and change the orientation and relative orientation of the electronic component and the bus bar within the surface mountable range. Therefore, it is possible to versatility and degree of freedom in the mounting of the electronic component is improved.

Bus bar stacked body and the electronic component mounting module or the like of the present invention is not limited to the configuration and method described in the above embodiment, appropriately within the scope of the invention as set forth in the appended claims.

### [Industrial applicability]

The present invention is suitable for a mounting module of a plurality of electronic components typical capacitor.

### [Description of Symbols]

- 1000: electronic component mounting module,
- 1100: capacitor,
- 1110: first lead terminal,
- 1120: second lead terminal,
- 1130: auxiliary terminal,
- 1200: pedestal,
- 1300: first bus bar,
- 1310: opening for protrusion body,
- 1400: insulating sheet,
- 1500: second bus bar,
- 1510: first electrode soldered protrusion body,
- 1600: heat sink,
- 1700: resin.

## Claims

1. A bus bar laminate stacked body according to the method of claim 6, laminated through an insulating member
(1400) with a plurality of mounted electronic components, a first bus bar (1300) and a second bus bar (1500) each comprising a region for soldering the external terminals (1110, 1120) of the electronic component, the first bus bar (1300) includes an opening (1310), the second bus bar (1500) protrudes to the first bus bar (1300) side, comprising a protrusion body (1510) is a region to be soldered, the protrusion body (1510) of the second bus bar (1500) is disposed at a position corresponding to the opening (1310), the region for soldering the protrusion body (1510) and the region for soldering the first bus bar (1300) of the bus bar stacked body, have the same height to the extent that soldering the external terminals (1110, 1120) of the electronic component by reflow soldering is possible.

2. Bus bar stacked body according to claim 1, wherein a first lead terminal (1110) and a second lead terminal (1120) respectively bent along the bottom surface is inserted through a pedestal (1200) and at least the distal end portion is in a state of protruding from the edge portion of the pedestal (1200).

3. An electronic component mounting module (1000), wherein the module comprises a
bus bar stacked body according to claim 1 and the external terminal (1110, 1120) at the first bus bar (1300) side which comprises the electronic component soldered.

4. The electronic component mounting module (1000) according to claim 3, wherein the
tip of the external terminal (1110, 1120) of the electronic component mounting module at least is disposed in the top of the protrusion body (1510).

5. The electronic component mounting module (1000) according to claim 3 or claim 4.
wherein the bus bar stacked body including a soldered region is resin molded at the electronic component mounting module.

6. Method for manufacturing a bus bar laminate comprising a plurality of mounted electronic components in which a first bus bar (1300) and a second bus bar (1400) are insulated and stacked, each having an area for soldering the external terminals (1110, 1120) of an electronic component, the method comprising, the step of forming an opening (1310) in said first bus bar (1300), the step of forming a protrusion body (1510) on said second bus bar (1500), which is an area protruding from said first bus bar (1300) side to be soldered, and the step of disposing said protrusion body (1510) of said second bus bar (1500) at a position corresponding to said opening (1310), and insulating and laminating said first bus bar (1300) and said second bus bar (1500), wherein the area to be soldered to the first bus bar (1300) and the area to be soldered to the protrusion body (1510) are at the same height to the extent that it is possible to solder the external terminals (1110, 1120) of the electronic components by reflow soldering.

## Patentansprüche

1. Stapelkörper mit laminierter Sammelschiene gemäß dem Verfahren nach Anspruch 6, der durch ein Isolierelement (1400) mit einer Mehrzahl von montierten elektronischen Komponenten laminiert ist, wobei eine erste Sammelschiene (1300) und eine zweite Sammelschiene (1500) jeweils einen Bereich zum Löten der externen Klemmen (1110, 1120) der elektronischen Komponente umfassen, wobei die erste Sammelschiene (1300) eine Öffnung (1310) umfasst, wobei die zweite Sammelschiene (1500) zur Seite der ersten Sammelschiene (1300) vorspringt, und umfassend einen Vorsprungkörper (1510), der ein zu lötender Bereich ist, wobei der Vorsprungkörper (1510) der zweiten Sammelschiene (1500) an einer Position angeordnet ist, die der Öffnung (1310) entspricht, wobei der Bereich zum Löten des Vorsprungkörpers (1510) und der Bereich zum Löten der ersten Sammelschiene (1300) des Stapelkörpers mit Sammelschiene dieselbe Höhe in dem Ausmaß aufweisen, dass ein Löten der externen Klemmen (1110, 1120) der elektronischen Komponente durch Reflow-Löten möglich ist.

2. Stapelkörper mit Sammelschiene nach Anspruch 1, wobei eine erste Führungsklemme (1110) und eine zweite Führungsklemme (1120), die jeweils entlang der unteren Oberfläche gebogen sind, durch ein Gestell (1200) eingeführt werden, und mindestens der distale Endabschnitt in einem Zustand des Vorspringens von dem Kantenabschnitt des Gestells (1200) ist.

3. Montagemodul für eine elektronische Komponente (1000), wobei das Modul einen Stapelkörper mit Sammelschiene nach Anspruch 1 und die externe Klemme (1110, 1120) auf der Seite der ersten Sammelschiene (1300) umfasst, die die gelötete elektronische Komponente umfasst.

4. Montagemodul für eine elektronische Komponente (1000) nach Anspruch 3, wobei die Spitze der externen Klemme (1110, 1120) des Montagemoduls für eine elektronische Komponente mindestens in der Oberseite des Vorsprungkörpers (1510) angeordnet ist.

5. Montagemodul für eine elektronische Komponente (1000) nach Anspruch 3 oder Anspruch 4, wobei der Stapelkörper mit Sammelschiene, der einen gelöteten Bereich umfasst, an das Montagemodul für eine elektronische Komponente geformtes Harz ist.

6. Verfahren zum Herstellen einer laminierten Sammelschiene, die eine Mehrzahl von montierten elektronischen Komponenten umfasst, in der eine erste Sammelschiene (1300) und eine zweite Sammelschiene (1400) isoliert und gestapelt sind, die jeweils eine Fläche zum Löten der externen Klemmen (1110, 1120) einer elektronischen Komponente aufweisen, das Verfahren umfassend den Schritt des Bildens einer Öffnung (1310) in der ersten Sammelschiene (1300), den Schritt des Bildens eines Vorsprungkörpers (1510) an der zweiten Sammelschiene (1500), der eine Fläche ist, die von der Seite der ersten Sammelschiene (1300), die gelötet werden soll, vorspringt, und den Schritt des Anordnens des Vorsprungkörpers (1510) der zweiten Sammelschiene (1500) an einer Position, die der Öffnung (1310) entspricht, und des Isolierens und Laminierens der ersten Sammelschiene (1300) und der zweiten Sammelschiene (1500), wobei die Fläche, die an die erste Sammelschiene (1300) gelötet werden soll, und die Fläche, die an den Vorsprungkörper (1510) gelötet werden soll, in dem Ausmaß auf derselben Höhe sind, dass es möglich ist, die externen Klemmen (1110, 1120) der elektronischen Komponenten durch Reflow-Löten zu löten.

## Revendications

1. Corps empilé stratifié de barres omnibus selon le procédé selon la revendication 6, stratifié à travers un élément isolant (1400) avec une pluralité de composants électroniques montés, une première barre omnibus (1300) et une deuxième barre omnibus (1500) comprenant chacune une région pour souder les bornes externes (1110, 1120) du composant électronique, la première barre omnibus (1300) comprend une ouverture (1310), la deuxième barre omnibus (1500) fait saillie sur le premier côté de la barre omnibus (1300), comprenant un corps saillant (1510) est une région à souder, le corps saillant (1510) de la deuxième barre omnibus (1500) est disposé à une position correspondant à l'ouverture (1310), la région de soudure du corps de saillie (1510) et la région de soudure de la première barre omnibus (1300) du corps empilé de barre omnibus, ont la même hauteur dans la mesure où il est possible de souder les bornes externes (1110, 1120) du composant électronique par soudure par refusion.

2. Corps empilé de barres omnibus selon la revendication 1, où une première borne de plomb (1110) et une deuxième borne de plomb (1120) respectivement pliées le long de la surface inférieure sont insérées à travers un socle (1200) et au moins la partie d'extrémité distale est dans un état de saillie de la partie de bord du socle (1200).

3. Un module de montage de composants électroniques (1000), où le module comprend un corps empilé de barres omnibus selon la revendication 1 et la borne externe (1110, 1120) du côté de la première barre omnibus (1300) qui comprend le composant électronique soudé.

4. Le module de montage de composants électroniques (1000) selon la revendication 3, où l'extrémité de la borne externe (1110, 1120) du module de montage de composants électroniques est au moins disposée dans la partie supérieure du corps de saillie (1510).

5. Le module de montage de composant électronique (1000) selon la revendication 3 ou la revendication 4, où le corps empilé de la barre omnibus, y compris une région soudée, est moulé en résine au niveau du module de montage de composants électroniques.

6. Procédé de fabrication d'un stratifié de barre omnibus comprenant une pluralité de composants électroniques montés dans lesquels une première barre omnibus (1300) et une deuxième barre omnibus (1400) sont isolées et empilées, chacune ayant une surface pour souder les bornes externes (1110, 1120) d'un composant électronique, le procédé comprenant l'étape consistant à former une ouverture (1310) dans ladite première barre omnibus (1300), l'étape consistant à former un corps de saillie (1510) sur ladite deuxième barre omnibus (1500), qui est une zone saillante dudit premier côté de la barre omnibus (1300) à souder, et l'étape consistant à disposer ledit corps saillant (1510) de ladite seconde barre omnibus (1500) à une position correspondant à ladite ouverture (1310), et à isoler et laminer ladite deuxième barre omnibus (1300) et ladite deuxième barre omnibus (1500), où la zone à souder à la première barre omnibus (1300) et la zone à souder au corps de saillie (1510) sont à la même hauteur dans la mesure où il est possible de souder les bornes externes (1110, 1120) des composants électroniques par soudure par refusion.
